# EUROPÄISCHE PATENTSCHRIFT

(11) **EP 3 113 911 B1**
(45) Veröffentlichungstag und Bekanntmachung des Hinweises auf die Patenterteilung: **02.05.2018**
(21) Anmeldenummer: 15707983.1
(22) Anmeldetag: 06.03.2015
(51) Int. Cl.: B23B 35/00, B28D 1/04, B28D 7/00, B23Q 5/14, F16H 3/00, F16H 3/44, G01P 3/00, H03K 5/08, B25F 5/00

(54) **ADAPTIVE LEISTUNGSANZEIGE**
ADAPTIVE POWER INDICATOR
AFFICHAGE DE PUISSANCE ADAPTATIF

(30) Priorität: 07.03.2014 EP 14158235
(43) Veröffentlichungstag der Anmeldung: 11.01.2017
(73) Patentinhaber: Hilti Aktiengesellschaft, 9494 Schaan (LI)
(72) Erfinder: SATTLER, Christian, 87640 Biessenhofen (DE)
(86) Internationale Anmeldenummer: PCT/EP2015/054703
(87) Internationale Veröffentlichungsnummer: WO 2015/132376

(56) Entgegenhaltungen:
- DE-A1- 3 433 552
- DE-A1- 10 348 756
- DE-A1-102011 089 771
- DE-U1-202009 018 270

## Beschreibung

Die vorliegende Erfindung bezieht sich auf ein Verfahren zum Steuern einer Werkzeugmaschine, insbesondere eine Kernbohrmaschine, enthaltend einen Motor als Antrieb für die Werkzeugmaschine, eine Steuerungseinrichtung, eine Leistungsanzeige; eine Getriebeeinrichtung mit wenigstens einem ersten Gang und einem zweiten Gang, einen ersten Sensor zum Erfassen der Drehzahl wenigstens eines Bauteils der Getriebeeinrichtung und einen zweiten Sensor zum Erfassen der Drehzahl des Motors.

Darüber hinaus bezieht sich die Erfindung auf eine Werkzeugmaschine, insbesondere eine Kernbohrmaschine, enthaltend einen Motor als Antrieb für die Werkzeugmaschine, eine Steuerungseinrichtung, eine Leistungsanzeige, eine Getriebeeinrichtung mit wenigstens einem ersten Gang und einem zweiten Gang, einen ersten Sensor zum Erfassen der Drehzahl wenigstens eines Bauteils der Getriebeeinrichtung und einen zweiten Sensor zum Erfassen der Drehzahl des Motors zur Anwendung des erfindungsgemässen Verfahrens.

Werkzeugmaschinen, wie z.B. Kernbohrmaschine dienen im Allgemeinen dazu Löcher in mineralische Werkstoffe, wie z.B. Beton oder Ziegel, zu schneiden. Das Kernbohrgerät enthält dabei für gewöhnlich einen Elektromotor, eine Getriebeeinrichtung, eine Steuerungseinrichtung bzw. ein Steuergerät, eine Werkzeugaufnahme sowie ein Werkzeug in Form einer Bohrkrone. Der Elektromotor treibt über die Getriebeeinrichtung die Werkzeugaufnahme samt Werkzeug an. Die Getriebeeinrichtung verfügt üblicherweise über zwei Gänge sowie einen Leerlauf, welche manuell durch den Anwender der Kernbohrmaschine einstellbar bzw. einlegbar sind. Mit Hilfe der einzelnen Gänge wird auf unterschiedliche Weise die Motordrehzahl auf die Antriebsdrehzahl übersetzt. Je nach Übersetzung können damit entweder eine hohe Drehzahl und ein niedriges Drehmoment oder eine niedrige Drehzahl und ein hohes Drehmoment an der Bohrkrone zur Verfügung stehen. Die in eine Drehbewegung versetzte Bohrkrone schneidet mit Hilfe des diamantenbesetzen Bohrkronenschneiderands ein ringförmiges Loch in den Werkstoff, wodurch ein zylindrischer Bohrkern entsteht. Dieser Bohrkern wird nach Beendigung des Bohr-bzw. Schneidevorgangs aus dem Bohrloch entfernt.

Eine Kernbohrmaschine gemäß dem Stand der Technik ist in der deutschen Patentanmeldung 10 2011 089 771 offenbart. Das als Kernbohrmaschine ausgestaltete Werkzeuggerät umfasst eine Antriebseinrichtung mit einem Antriebsmotor und einer Antriebswelle, eine Abtriebseinrichtung mit einer Abtriebswelle, eine Getriebeeinrichtung mit einem Planetengetriebe und einer weiteren Getriebeeinheit sowie eine Vorrichtung zum Schalten zwischen einer ersten und zweiten Obersetzungsstufe des Planetengetriebes.

Ein weit verbreitetes Problem bei den Kernbohrmaschinen gemäß dem Stand der Technik besteht darin, dass die Grenzwerte für die Überlastbereiche an dem sich am langsamsten drehenden Gang (d.h. am höchsten Gang) ausgelegt sind. Diese Grenzwerte sind jedoch nicht auf die sich am schnellsten drehenden Gänge (d.h. die niedrigsten Gänge) abgestimmt. Das Anzeigen von einem nicht auf den jeweils eingelegten Gang abgestimmten Grenzwert kann zu einer Fehlbedienung der Werkzeugmaschine und zu einer verringerten Produktivität durch langsamere Bohrgeschwindigkeiten und/oder verkürzte Standzeiten der Werkzeugmaschine führen.

**Aufgabe der vorliegenden Erfindung** ist es dieses vorstehend beschriebene Problem zu lösen und ein Verfahren zum Steuern einer Werkzeugmaschine, insbesondere eine Kernbohrmaschine, sowie eine Werkzeugmaschine, insbesondere eine Kernbohrmaschine, zur Verwendung dieses Verfahrens zur Verfügung zu stellen, mit dem eine höhere Produktivität bei der Verwendung der Werkzeugmaschine erreicht werden kann.

Diese **Aufgabe** wird erfindungsgemäss durch den Gegenstand des unabhängigen Anspruchs 1 und 2 gelöst.

Hierzu ist ein Verfahren gezeigt zum Steuern einer Werkzeugmaschine, insbesondere eine Kernbohrmaschine, enthaltend
- einen Motor als Antrieb für die Werkzeugmaschine;
- eine Steuerungseinrichtung;
- eine Leistungsanzeige;
- eine Getriebeeinrichtung mit wenigstens einem ersten Gang und einem zweiten Gang;
- einen ersten Sensor zum Erfassen der Drehzahl wenigstens eines Bauteils der Getriebeeinrichtung; und
- einen zweiten Sensor zum Erfassen der Drehzahl des Motors.

Erfindungsgemäss sind die Verfahrensschritte:
- Ermitteln einer ersten Drehzahl des wenigstens einen Bauteils der Getriebeeinrichtung, wenn die Getriebeeinrichtung in einem Gang eingestellt ist,
- Ermitteln einer ersten Drehzahl des Motors, wenn die Getriebeeinrichtung in einem Gang eingestellt ist,
- Ermitteln des Einlegens des Gangs anhand eines ersten vorbestimmten Verhältnisses der ersten Drehzahl des wenigstens einen Bauteils der Getriebeeinrichtung und der ersten Drehzahl des Motors entsprechend einer Lookup-Tabelle; und
- Einstellen des Grenzwertes der Leistungsanzeige anhand der Lookup-Tabelle entsprechend zu dem eingelegten Gang
   vorgesehen. Durch die entsprechende automatische Anpassung des Grenzwertes der Leistungsanzeige auf den jeweils eingelegten Gang ist der Anwender in der Lage die Werkzeugmaschine stets in dem entsprechenden Leistungsspektrum zur Steigerung der Produktivität zu verwenden.

Darüber hinaus ist eine Werkzeugmaschine gezeigt, insbesondere eine Kernbohrmaschine, enthaltend
- einen Motor als Antrieb für die Werkzeugmaschine;
- eine Steuerungseinrichtung;
- eine Leistungsanzeige;
- eine Getriebeeinrichtung mit wenigstens einem ersten Gang und einem zweiten Gang;
- einen ersten Sensor zum Erfassen der Drehzahl wenigstens eines Bauteils der Getriebeeinrichtung; und
- einen zweiten Sensor zum Erfassen der Drehzahl des Motors zur Durchführung des erfindungsgemäßen Verfahrens.

Weitere Vorteile ergeben sich aus der folgenden Figurenbeschreibung. In den Figuren sind verschiedene Ausführungsbeispiele der vorliegenden Erfindung dargestellt. Die Figuren, die Beschreibung und die Ansprüche enthalten zahlreiche Merkmale in Kombination. Der Fachmann wird die Merkmale zweckmässigerweise auch einzeln betrachten und zu sinnvollen weiteren Kombinationen zusammenfassen.

Es zeigen:
- Fig. 1: eine erfindungsgemässe als Kernbohrmaschine ausgebildete Werkzeugmaschine mit einem Motor, einer Steuerungseinrichtung, einer Getriebeeinrichtung, einem als Bohrkrone ausgebildeten Werkzeug, einem ersten Sensor und einem zweiten Sensor; und
- Fig. 2: ein Ablaufdiagramm des erfindungsgemässen Verfahrens.

### Ausführungsbeispiel:

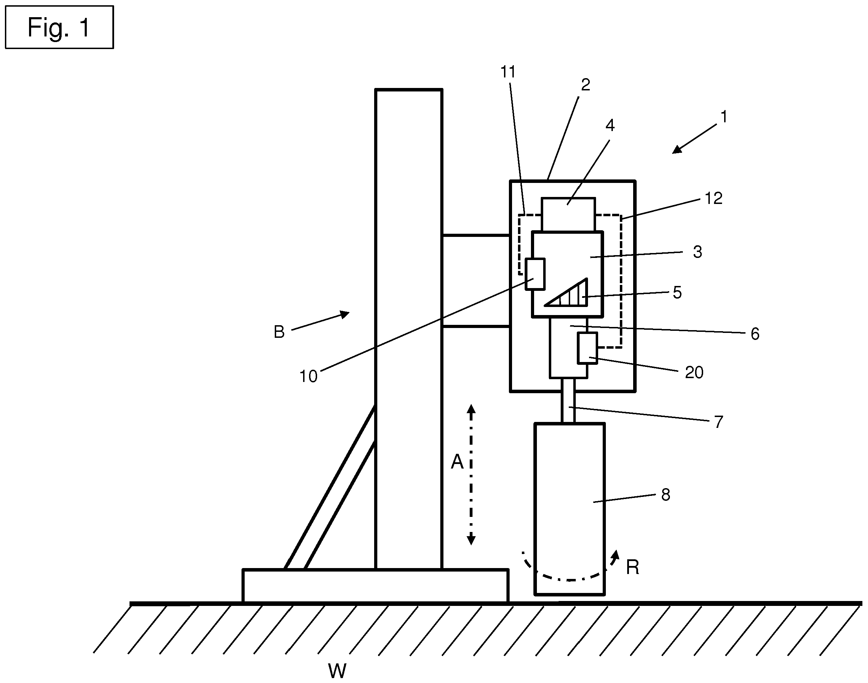

Fig. 1 zeigte eine als Kernbohrmaschine 1 ausgestaltete Werkzeugmaschine, die an einem Bohrständer B befestigt ist. Mit Hilfe des Bohrständers 2 kann die Kernbohrmaschine 1 entlang der Doppelpfeilrichtung A reversibel auf das zu bearbeitende Werkstück W zu- und wieder wegbewegt werden. Bei dem Werkstoff W handelt es sich um Beton.

Die Kernbohrmaschine 1 enthält ein Gehäuse 2, einen Motor 3, eine Steuerungseinrichtung 4, eine Leistungsanzeige 5, eine Getriebeeinrichtung 6, eine Abtriebswelle 7, ein als Bohrkrone ausgestaltetes Werkzeug 8, einen ersten Sensor 10 zum Erfassen der Drehzahl der Getriebeeinrichtung 6 und einen zweiten Sensor 20 zum Erfassen der Drehzahl des Motors 3. Als Motor 3 kann jegliche Art von Elektromotor eingesetzt werden.

Der Motor 3 ist als Elektromotor ausgestaltet und dient zum Antreiben der Bohrkrone 8. Der Motor 3 enthält eine (nicht gezeigte) Antriebswelle, welche mit der Getriebeeinrichtung 6 lösbar verbunden. Die Verbindung wird über eine nicht gezeigte Kupplung verwirklicht. Über die Getriebeeinrichtung 6 und die Abtriebswelle 7 wird die Bohrkrone 8 in eine Drehbewegung versetzt. Das in dem Motor 3 erzeugte Drehmoment wird somit auf die Bohrkrone 8 entsprechend übertragen, um ein Bohrloch in den Werkstoff W zu schneiden.

Die Getriebeeinrichtung 6 enthält einen ersten Gang, einen zweiten Gang und einen Leerlaufgang und ist zwischen der Antriebswelle des Motors 3 und der Abtriebswelle 7 positioniert. Die einzelnen Gänge lassen sich manuell über eine (nicht gezeigte) Gangwahleinrichtung einstellen, um somit die Übersetzung der Drehzahl und des Drehmoments von dem Motor 3 zu der Abtriebswelle 7 bzw. Bohrkrone 8 zu variieren.

Der erste Sensor 10 ist so an der Getriebeeinrichtung 6 positioniert, dass die Drehzahl wenigstens eines Bauteils der Getriebeeinrichtung 6 in Bezug auf den jeweils eingestellten Gang erfasst wird. Bei dem wenigstens einen Bauteil der Getriebeeinrichtung 6 kann es sich um ein Zahnrad oder ähnliches handeln. Der zweite Sensor 20 ist hingegen so positioniert, dass die Drehzahl des Motors 3 erfasst wird.

Die Steuerungseinrichtung 4 ist über eine erste Leitung 11 mit dem ersten Sensor 10 und über eine zweite Leitung 12 mit dem zweiten Sensor 20 so verbunden, dass die von den Sensoren 10, 20 gemessenen Drehzahlwerte zu der Steuerungseinrichtung 4 übertragen werden. Darüber hinaus ist die Steuerungseinrichtung 4 so mit dem Motor 3 verbunden, dass die Steuerungseinrichtung 4 direkt die Drehzahl des Motors 3 variieren kann. Des Weiteren ist die Steuerungseinrichtung 4 auch so mit der Leistungsanzeige 5 verbunden, dass diese die Grenzwerte der Leistungsanzeige 5 variiert (d.h. erhöht oder verringert) werden können. Die Steuerungseinrichtung 4 enthält einen Datenspeicher, in dem eine Lookup-Tabelle (Übersetzungstabelle) hinterlegt ist. Durch diese Lookup-Tabelle ist der jeweils eingelegte Gang anhand des Verhältnisses der Drehzahl des Motors 3 und der dazu entsprechenden Drehzahl der Getriebeeinrichtung 6 ermittelbar. Durch die Verbindung der Steuerungseinrichtung 4 zu dem Motor 3 kann diese auf die Drehzahl des Motors 3 einwirken, d.h. die Drehzahl des Motors 3 entweder automatisch erhöhen oder verringern.

Die Leistungsanzeige 5 dient dazu den Anwender über das aktuelle Leistungsvermögen der Kernbohrmaschine 1 zu informieren, d.h. insbesondere den Anwender vor einer Überlastung der Kernbohrmaschine 1 zu warnen. Hierzu ist die Leistungsanzeige 5 sichtbar so an dem Gehäuse 2 der Kernbohrmaschine 1 positioniert, dass der Verwender diese beim Arbeiten mit der Kernbohrmaschine 1 einsehen kann. Die Leistungsanzeige 5 enthält eine visuelle Skala (Gradeinteilung), mit der der Leistungsbereich und insbesondere der Überlastbereich in Bezug auf den jeweils eingelegten Gang angezeigt werden. Alternativ oder auch zusätzlich zu der visuellen Skala kann auch eine akustische Anzeigevorrichtung vorgesehen sein, mit der das Erreichen und insbesondere das Überschreiten des Überlastbereichs angezeigt werden kann.

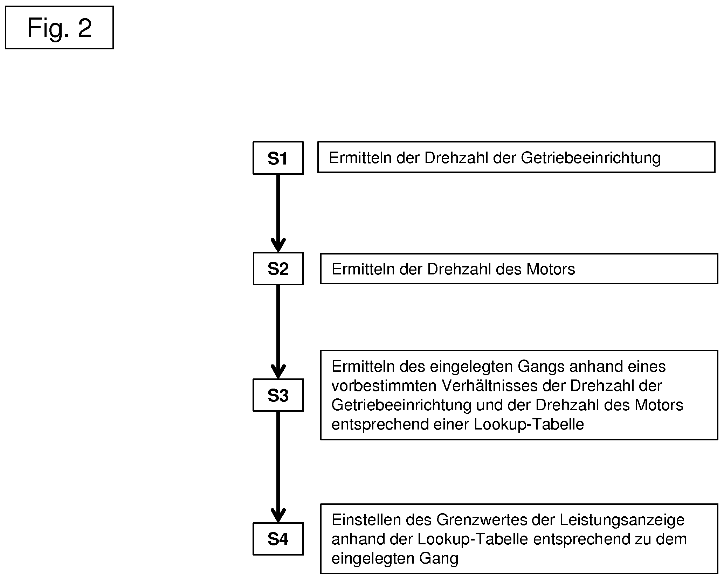

Fig. 2 zeigt den Ablauf des Anpassens des Grenzwertes an einen eingelegten Gang gemäß dem erfindungsgemäßen Verfahrens.

Hierzu wird im Schritt **S1** zunächst durch den ersten Sensor 10 die Drehzahl der Getriebeeinrichtung 6 ermittelt.

Im Schritt **S2** wird durch den zweiten Sensor 20 die Drehzahl des Motors 3 ermittelt.

Im Schritt **S3** wird mittels der im Datenspeicher hinterlegten Lookup-Tabelle sowie der ermittelten Drehzahl des Motors 3 und der Getriebeeinrichtung 6 der eingelegte Gang bestimmt.

Im Schritt **S4** wird anhand der Lookup-Tabelle entsprechend dem eingelegten Gang der Grenzwert der Leistungsanzeige 5 eingestellt.

## Patentansprüche

1. Verfahren zum Steuern einer Werkzeugmaschine (1), insbesondere eine Kernbohrmaschine, enthaltend
- einen Motor (3) als Antrieb für die Werkzeugmaschine (1);
- eine Steuerungseinrichtung (4);
- eine Leistungsanzeige (5);
- eine Getriebeeinrichtung (6) mit wenigstens einem ersten Gang und einem zweiten Gang;
- einen ersten Sensor (10) zum Erfassen der Drehzahl wenigstens eines Bauteils der Getriebeeinrichtung (6); und
- einen zweiten Sensor (20) zum Erfassen der Drehzahl des Motors (3)
**gekennzeichnet durch** die Verfahrensschritte
- Ermitteln einer ersten Drehzahl des wenigstens einen Bauteils der Getriebeeinrichtung (6), wenn die Getriebeeinrichtung (6) in einem Gang eingestellt ist,
- Ermitteln einer ersten Drehzahl des Motors (3), wenn die Getriebeeinrichtung (6) in einem Gang eingestellt ist,
- Ermitteln des Einlegens des Gangs anhand eines ersten vorbestimmten Verhältnisses der ersten Drehzahl des wenigstens einen Bauteils der Getriebeeinrichtung (6) und der ersten Drehzahl des Motors (3) entsprechend einer Lookup-Tabelle; und
- Einstellen des Grenzwertes der Leistungsanzeige (5) anhand der Lookup-Tabelle entsprechend zu dem eingelegten Gang.

2. Werkzeugmaschine (1), insbesondere eine Kernbohrmaschine, enthaltend
- einen Motor (3) als Antrieb für die Werkzeugmaschine (1);
- eine Steuerungseinrichtung (4);
- eine Leistungsanzeige (5);
- eine Getriebeeinrichtung (6) mit wenigstens einem ersten Gang und einem zweiten Gang;
- einen ersten Sensor (10) zum Erfassen der Drehzahl wenigstens eines Bauteils der Getriebeeinrichtung (6); und
- einen zweiten Sensor (20) zum Erfassen der Drehzahl des Motors (3) zur Durchführung des Verfahrens nach Anspruch 1.

## Claims

1. Method for controlling a machine tool (1), in particular a core drill, comprising
- a motor (3) as the drive for the machine tool (1);
- a control device (4);
- a power display (5);
- a transmission system (6) having at least a first gear and a second gear;
- a first sensor (10) for detecting the rotational speed of at least one component of the transmission system (6); and
- a second sensor (20) for detecting a rotational speed of the motor (3)
**characterised by** the process steps:
- determining a first rotational speed of the at least one component of the transmission system (6) when a gear is engaged in the transmission system (6),
- determining a first rotational speed of the motor (3) when a gear is engaged in the transmission system (6),
- determining the selection of the gear with reference to a first predetermined ratio between the first rotational speed of the at least one component of the transmission system (6) and the first rotational speed of the motor (3) in accordance with a lookup table; and
- setting the limit value of the power display (5) with reference to the lookup table in accordance with the selected gear.

2. Machine tool (1), in particular a core drill, comprising
- a motor (3) as the drive for the machine tool (1);
- a control device (4);
- a power display (5);
- a transmission system (6) having at least a first gear and a second gear;
- a first sensor (10) for detecting the rotational speed of at least one component of the transmission system (6); and
- a second sensor (20) for detecting a rotational speed of the motor (3), for carrying out the method according to Claim 1.

## Revendications

1. Procédé pour commander une machine-outil (1), en particulier une carotteuse, contenant :
- un moteur (3) faisant office d'organe d'entraînement pour la machine-outil (1),
- un dispositif de commande (4),
- un affichage de puissance (5),
- un dispositif de transmission (6) ayant au moins une première allure et une seconde allure,
- un premier capteur (10) pour détecter la vitesse de rotation d'au moins un composant du dispositif de transmission (6), et
- un second capteur (20) pour détecter la vitesse de rotation du moteur (3),
**caractérisé par** les étapes de procédé consistant à :
- déterminer une première vitesse de rotation dudit au moins un composant du dispositif de transmission (6) lorsque le dispositif de transmission (6) est réglé à une allure,
- déterminer une première vitesse de rotation du moteur (3) lorsque le dispositif de transmission (6) est réglé à une allure,
- déterminer la sélection de l'allure au moyen d'un premier rapport prédéterminé entre la première vitesse de rotation dudit au moins un composant du dispositif de transmission (6) et la première vitesse de rotation du moteur (3) en fonction d'une table de consultation, et
- régler la valeur limite de l'affichage de puissance (5) au moyen de la table de consultation en fonction de l'allure sélectionnée.

2. Machine-outil (1), en particulier une carotteuse, contenant :
- un moteur (3) faisant office d'organe d'entraînement pour la machine-outil (1),
- un dispositif de commande (4),
- un affichage de puissance (5),
- un dispositif de transmission (6) ayant au moins une première allure et une seconde allure,
- un premier capteur (10) pour détecter la vitesse de rotation d'au moins un composant du dispositif de transmission (6), et
- un second capteur (20) pour détecter la vitesse de rotation du moteur (3)
pour mettre en oeuvre le procédé selon la revendication 1.
